# EUROPEAN PATENT SPECIFICATION

(11) **EP 3 401 728 B1**
(45) Date of publication and mention of the grant of the patent: **06.05.2020**
(21) Application number: 17203948.9
(22) Date of filing: 28.11.2017
(51) Int. Cl.: G02F 1/1335, G09G 3/36

(54) **DISPLAY PANEL**
ANZEIGETAFEL
PANNEAU D'AFFICHAGE

(30) Priority: 08.05.2017 CN 201710318432
(43) Date of publication of application: 14.11.2018
(73) Proprietor: Beijing Xiaomi Mobile Software Co., Ltd., Beijing 100085 (CN)
(72) Inventor: LI, Guosheng, Beijing, Beijing 100085 (CN)
(74) Representative: dompatent von Kreisler Selting Werner - Partnerschaft von Patent- und Rechtsanwälten mbB

(56) References cited:
- CN-A- 107 221 294
- US-A1- 2016 063 936
- US-A1- 2016 197 104

## Description

### TECHNICAL FIELD

The present disclosure relates to the field of display technology, and particularly to a display panel.

### BACKGROUND

Display panels are one of the most commonly used input and output devices in electronic devices. A display panel has functions of displaying text information and image information. Liquid crystal display (LCD) panels are a kind of commonly used display panel.

A LCD panel includes a plurality of display units of pixels, each display unit of the pixels may be divided into display subunits corresponding to red, green and blue color channels, respectively, and each display subunit may include a driving circuit, a liquid crystal layer, and color filters. The liquid crystal display panel may include a backlight for providing light for each of the display subunits, and a polarizing plate for changing the direction of the light.

In carrying out the present disclosure, the inventors have found that the prior art has at least the following problems:

Display subunit color filters are red, green and blue three-color filters, and the red, green and blue three-color filters have relatively poor light transmission capacity. In this situation, if higher screen brightness is required, then the light intensity the backlight has to be significantly increased, and more power has to be consumed.

US 2016/197104 discloses a display device including red, blue, green and white pixels, wherein the size of the white pixel is larger than or equal to those of the other pixels.

### SUMMARY

In order to solve the problems of the prior art, the embodiment of the present disclosure provides a display panel as recited in the appended claims. The technical scheme is as follows:

In the embodiments of the present disclosure, it is provided a display panel, the display panel includes a plurality of display units of pixels, each of the display units including a display subunit corresponding to a white channel and display subunits corresponding to a plurality of primary color channels, wherein display areas of the display subunits corresponding to the plurality of primary color channels are equal, and the display area of the display subunit corresponding to the white channel is larger than the display area of each display subunit corresponding to each primary color channel.

Optionally, the plurality of primary color channels includes a red channel, a blue channel, and a green channel.

In this way, different colors of pixels can be formed based on red, green, blue three primary color channels.

Optionally, the display areas of the display subunits corresponding to the plurality of primary color channels and the display area of the display subunit corresponding to the white channel are rectangular display areas arranged parallel with each other and the lengths of the rectangular display areas are equal.

Optionally, the rectangular display areas of the display subunits in each of the display units are arranged in the same order, and are parallel with each other with long-sides thereof being arranged vertically.

Optionally, the rectangular display areas of the display subunits in each of the display units are arranged in the same order, and are parallel with each other with long-sides thereof being arranged horizontally.

Optionally, the display area of the display subunit corresponding to the white channel is less than half of the display area of the display unit.

In this way, it can be avoided that the white channel has too much impact on pixel color accuracy.

Optionally, the display area of the display subunit corresponding to the white channel accounts for 1/3 of the display area of the display unit.

In accordance with the present invention as recited in the appended claims, each of the display subunits comprises a TFT.

Further, the display panel includes a first gate circuit, a second gate circuit, and a data circuit, a source electrode of each of the TFT switches is connected to the data circuit, a gate electrode of the TFT switch of the display subunit corresponding to each of the primary color channels is connected to the first gate circuit, and a gate electrode of the TFT switch of the display subunit corresponding to each of the white channels is connected to the second gate circuit.

In this way, the turn-on or turn-off of the TFTs in the display subunits corresponding to the white channel and each of the primary color channels may be controlled by the first gate circuit and the second gate circuit, respectively.

The beneficial effects of the technical solution provided by the embodiments of the present disclosure are as follows:

In the embodiments of the present disclosure, the display panel includes a plurality of display units of pixels, each of the display units including a display subunit corresponding to a white channel and display subunits corresponding to a plurality of primary color channels, wherein display areas of the display subunits corresponding to the plurality of primary color channels are equal, and the display area of the display subunit corresponding to the white channel is larger than the display area of each display subunit corresponding to each primary color channel. In this way, the display subunit corresponding to the white channel, which has a large display area, is added to each pixel. The color filter of the display subunit corresponding to the white channel has a strong light-transmitting ability. Thus, in case of the same requirement for the brightness of the screen , with the display panel provided in the present solution, a lower light intensity of the backlight can be used, and thereby the power consumed by the backlight can be saved.

### BRIEF DESCRIPTION OF THE DRAWINGS

The drawings herein are incorporated in and constitute a part of the specification, showing embodiments consistent with the present disclosure and, together with the description, serve to explain the principles of the present disclosure. In the drawings:
Figure 1 is a schematic structural diagram of a display panel according to an exemplary embodiment;
Figure 2 is a schematic diagram of an arrangement of each color channel display area according to an exemplary embodiment;
Figure 3 is a schematic diagram of an arrangement of each color channel display area according to an exemplary embodiment;
Figure 4 is a schematic structural diagram of a display subunit according to an exemplary embodiment;
Figure 5 is a schematic structural diagram of a display unit according to a comparative embodiment;

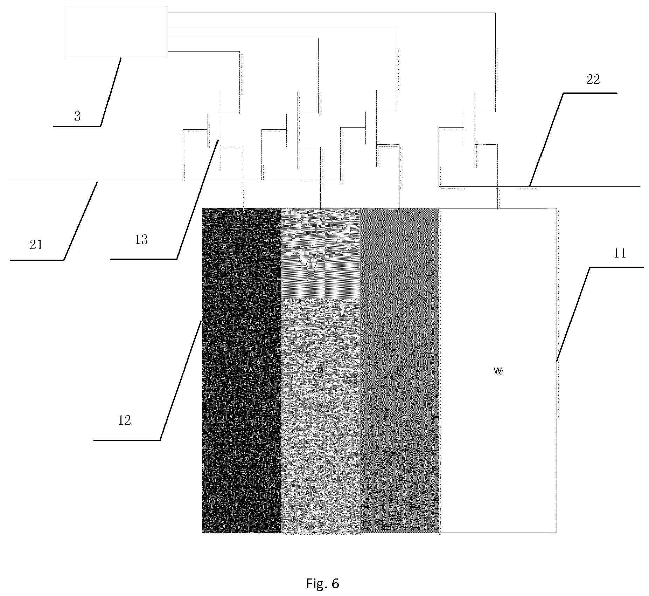

Figure 6 is a schematic structural diagram of a display unit according to an exemplary embodiment;

Throughout the drawings, there have been shown the embodiments disclosed by the present disclosure, which will be described in more detail hereinafter. These drawings and textual description are not intended to limit the scope of the present disclosure by any means, but rather to teach those skilled in the art, by reference to specific embodiments, the concepts of the present disclosure.

### Descriptions of Reference Numerals in the Drawings:

1. Display unit; 11. Display subunit corresponding to the white channel;
12. Display subunit corresponding to the primary color channel; 13.TFT;
2. Gate circuit; 21. The First gate circuit;22. The second gate circuit;3. Data circuit

### DETAILED DESCRIPTION

The present disclosure will be described in more details with reference to the accompanying drawings, in which the objects, technical solutions and advantages of the present disclosure will become more apparent from the following description.

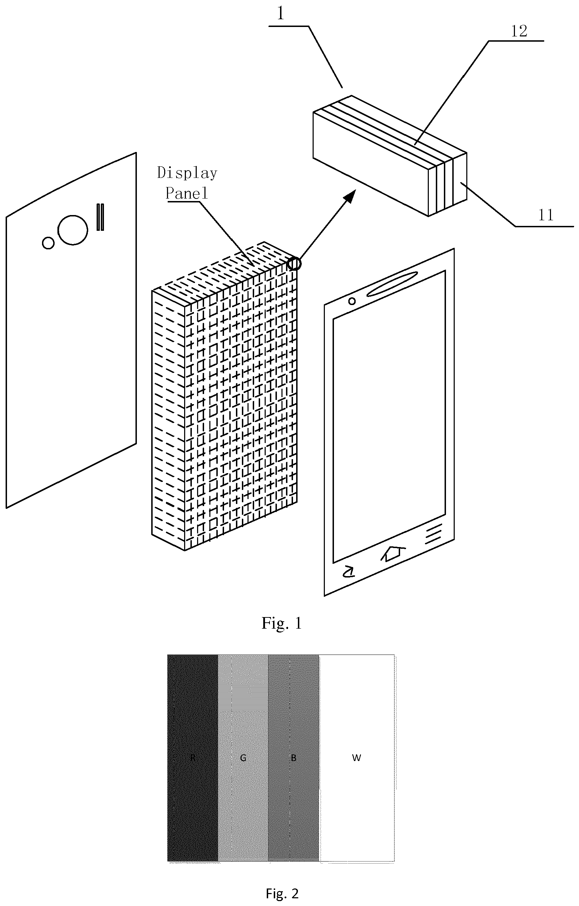

The embodiment of the present disclosure provides a display panel, as shown in Figure 1, the display panel includes a plurality of display units 1 of a plurality of pixels, each display unit including a display subunit 11 corresponding to a white channel and a plurality of display subunits 12 corresponding to primary color channels, wherein the display areas of the display subunits 12 corresponding to the plurality of primary color channels are equal to each other, and the display area of the display subunit 11 corresponding to the white channel is larger than the display area of the display subunit 12 corresponding to each primary color channel.

In the embodiment, the display panel may be a liquid crystal display panel, or an OLED display panel. When it is a liquid crystal display panel, the display unit 1 of each pixel may include a driving circuit, which may include a gate circuit and a data circuit, a liquid crystal layer and a color filter. When it is an OLED display panel, the display unit of each pixel may include a light emitting diode and color filters. In the present embodiment, a liquid crystal display panel is described as an example, and the OLED display panel is similar with that, and thus the details thereof is omitted in the present embodiment.

In the implementation, the display units 1 of a plurality of pixels is arranged in the display panel, each of the display units 1 is used for displaying the corresponding pixel on the screen when an image is displayed. For example, a display panel can display an image containing 1000 ^{∗} 1000 pixels, which may indicate that the display panel contains 1000 ^{∗} 1000 display units 1. Each pixel in the display panel may include one white channel and a plurality of primary color channels, that is, each pixel may include a white sub-pixel and a plurality of sub-pixels of primary colors. The display unit corresponding to each color channel can control the color of the corresponding sub-pixels. In this way, the plurality of sub-pixels are combined together, so that the pixel can display different colors.

Further, in each pixel, the display areas of the display subunits 12 corresponding to the plurality of primary color channels are equal to each other, and the display area of the display subunit 11 corresponding to the white channel is larger than the display area of each display subunit 12 corresponding to each of the primary color channels. As the light transmission rate of the white channel is much larger than those of the other primary color channels, with the same backlight power, the brightness of the screen can be effectively improved by using such a display panel comprising a white channel and a plurality of primary color channels. From other point of view, to reach a certain brightness of screen, by using the display panel disclosed in the present embodiment, the brightness requirement of the backlight is relatively lower, so the power consumed by the backlight is lower. In addition, in the present embodiment, since the display area of the display subunit 11 corresponding to the white channel (also referred to as the white display area) is larger than the display area of each display subunit 12 corresponding to each primary color channel (also referred to as the primary color display area), with the same backlight intensity, the display panel disclosed in this embodiment can provide a higher screen brightness, and likewise, if the screen needs to reach a certain brightness, the backlight intensity can be relatively lower.

Optionally, the plurality of primary color channels includes a red channel, a blue channel, and a green channel.

In the implementation, each pixel may include three primary sub-pixels and one white sub-pixel, and the three primary sub-pixels correspond to three primary color channels. Particularly, the primary color channels may include a red channel, a green channel and a blue channel. In this way, color filters in the display subunit 12 corresponding to the primary color channels may be a red filter, a green filter, and a blue filter, respectively.

Optionally, the display areas of the display subunits 12 corresponding to the plurality of primary color channels and the display subunit 11 corresponding to the white channel are rectangular display areas arranged in a parallel way, and the length thereof is equal to each other.

In the implementation, the display areas of the display subunit 12 corresponding to the plurality of primary color channels and the display area of the display subunit 11 corresponding to the white channel may be rectangular display areas, and the lengths of the long sides of the rectangular display areas are equal to each other, and those display areas are arranged in a parallel way. It is not difficult to understand that since the areas of the display area of the display subunits 12 corresponding to the plurality of primary color channels are equal to each other, the area of the display area 11 of the display subunit corresponding to the white channel is larger than that of the display subunits 12, and the lengths of long sides of the display subunits are equal, then the width of the rectangular display area corresponding to the white channel is larger than the widths of the rectangular display areas corresponding to the primary color channels.

Alternatively, in the case where the display area of the display subunit is a rectangular display area, in the present embodiment, two possible display area arrangement are provided:
Mode 1: the rectangular display areas of the respective display subunits in each display unit 1 are arranged in the same order and are parallel with each other with their long sides arranged in a vertical direction.
   In the implementation, the rectangular display areas of the respective display subunits in each display unit 1 are arranged in the same order of color arrangement and are parallel with each other with their long sides arranged in the vertical direction, as shown in Fig. 2. In this embodiment, as an example, the three primary colors may include red, green and blue colors, in each display unit 1, it is arranged in a form of one row and a plurality of columns in the order of red (corresponding to R area), green (corresponding to G area), blue (corresponding to B area), and white (corresponding to W area).
Mode 2: the rectangular display areas of the respective display subunits in each display unit 1 are arranged in the same order and are parallel with each other with their long sides being arranged in a horizontal direction.

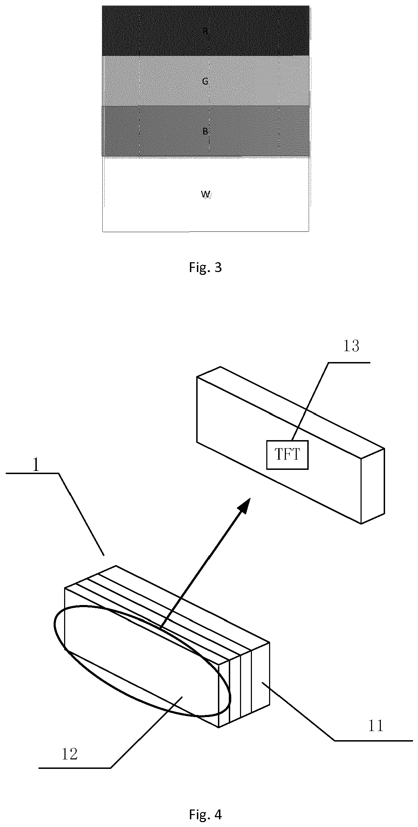

In the implementation, the rectangular display areas of the respective display subunits in each display unit 1 are arranged in the same order of color arrangement, and are parallel with each other, with their long-sides arranged in the horizontal direction, as shown in Fig. 3. In this embodiment, as an example, the three primary colors include red, green and blue colors. And in each of the display units 1, it is arranged in a form of one column and a plurality of rows, in the order of red, green, blue, and white.

Optionally, the display area of the display subunit 11 corresponding to the white channel may be less than half of the display area of the display unit 1.

In the implementation, the white channel will affect the accuracy of color display, that is to say, the size of the white channel display area will not only affect the screen brightness under the same backlight intensity, but also the display color of the pixels on the screen. Due to the above fact, the larger the display area of the display subunit 11 corresponding to the white channel is, the brighter the screen will be, and the more inaccurate the display color of the pixel will be. Therefore, the display area of the display subunit 11 corresponding to the white channel in the display panel should not be too large, and should be less than half of the display area of the display unit 1 of each pixel (also referred to as the pixel display area), that is, 1/4 pixel display area < white display area < 1/2 pixel display area. In this way, the brightness of the screen under the same backlight intensity can be increased, and at the same time, each pixel display color will not deviate too much from the original color.

Optionally, the display area of the display subunit 11 corresponding to the white channel accounts for 1/3 of the display area of the display unit 1.

In the implementation, since the display area of the display subunit 11 corresponding to the white channel should be larger than the display area of the display subunit 12 corresponding to each of the primary color channels and smaller than half of the display area of the display unit 1 of each pixel, the display area of the display subunit 11 corresponding to the white channel may be selected to account for 1/3 of the display area of each display unit 1. In this way, the brightness of the screen under the same backlight intensity can be increased, and at the same time, each pixel display color may not deviate too much from the original color.

Optionally, each of the display subunits comprises a TFT 13, as shown in Fig. 4.

In the implementation, when the display panel is a liquid crystal display panel, each display subunit may include a transistor switch for driving liquid crystal molecules in the liquid crystal layer, which may be selected as a TFT (Thin Film Transistor). When a high voltage is applied to the gate electrode of the TFT 13, the TFT 13 is turned on between the source electrode and the drain electrode thereof. In this way, the data circuit may apply a voltage converted from the digital signal to the liquid crystal layer, so that the rotation of the liquid crystal molecules in the liquid crystal layer can be controlled to change the intensity of the light passing through the liquid crystal layer.

Optionally, there may be a plurality of circuit connection modes of the TFT 13 in each display subunit. Two possible connection modes are given as follows, whereby only the second mode falls within the scope of the appended claims:

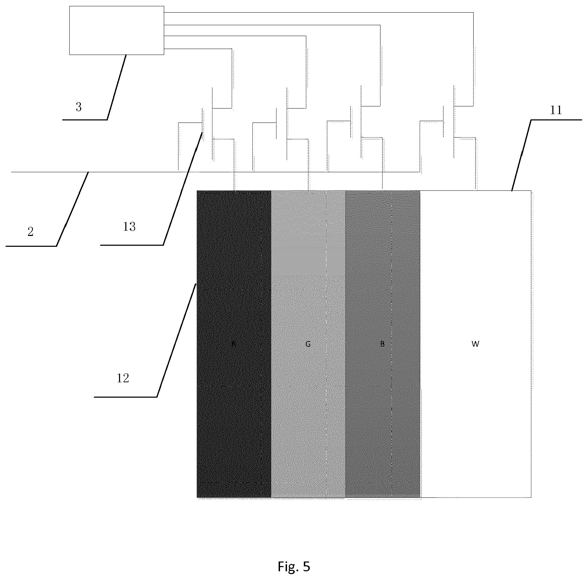

In mode 1, as shown in Fig. 5 and which does not form part of the present invention, the display panel includes a gate circuit 2 and a data circuit 3. The gate electrode of each TFT 13 is connected to the gate circuit 2, and the source electrode thereof is connected to the data circuit 3.

In the implementation, when the display panel is a liquid crystal display panel, the display panel may include a gate circuit and a data circuit, wherein the gate electrode of each TFT 13 of the display subunit may be connected to the gate circuit, and the source electrode is connected to the data circuit. In this way, the conduction of the TFT 13 of each display subunit can be controlled by a common gate circuit. When the gate circuit is turned on, a high voltage may be applied to the gate electrode of the TFT 13 , and at this time, the source electrode and the drain electrode of the TFT 13 are turned on. Further, the data voltage (the data voltage is the voltage obtained by converting the image data by the data circuit) originally applied to the source electrode of the TFT 13 can be directly applied to the liquid crystal layer of each display subunit through the turned on source electrode and the drain electrode of the TFT 13, so that the rotation of the liquid crystal molecules in the liquid crystal layer can be controlled to change the intensity of the light passing through the liquid crystal layer.

It should be noted that the display panel provided in this comparative embodiment can support the display mode one in which the display subunit 11 corresponding to the white channel operates alone, and also can support the display mode two in which only the display subunit 12 corresponding to the plurality of primary color channels is operated (i.e., the display subunit 11 corresponding to the white channel in this mode does not operate), and still can support the display mode three in which the display subunit 11 corresponding to the white channel and the display subunit 12 corresponding to the plurality of primary color channels both operate. After the gate circuit is turned on, the data circuit output of the display subunit 12 corresponding to the plurality of primary color channels can be controlled to be zero, that is, the display mode one is realized; or alternatively, the data circuit output of the display subunit 11 corresponding to the white channel can be controlled to be zero, that is, the display mode two is realized.

In mode 2, the display panel includes a first gate circuit 21, a second gate circuit 22, and a data circuit 3. The source electrode of each TFT switch is connected to the data circuit 3, and the gate electrode of the TFT switch of the display subunit 12 corresponding to each of the primary color channels is connected to the first gate circuit 21, and the gate electrode of the TFT switch of the display subunit 11 corresponding to each white channel is connected to the second gate circuit 22.

In this implementation of the claimed invention, when the display panel is a liquid crystal display panel, the display panel may include a first gate 21, a second gate 22, and a data circuit 3, wherein the source electrode of each TFT switch is connected to the data circuit 3, the gate electrode of the TFT switch of the display subunit 12 corresponding to each of the primary color channels is connected to the first gate circuit 21, and the gate electrode of the TFT switch of the display subunit 11 corresponding to each white channel is connected to the second gate circuit 22. In this way, the TFT of the display subunit 11 corresponding to each of the primary color channels can be controlled by the first gate circuit 21, and the TFT of the display subunit 11 corresponding to the white channel can be controlled by the second gate circuit 22.

It should be noted that the display panel provided in the present embodiment can support the display mode one in which the display subunit 11 corresponding to the white channel operates alone, and also can support the display mode two in which only the display subunits 12 corresponding to the plurality of primary color channels operate (i.e., the display subunit 11 corresponding to the white channel in this mode does not operate), and still can support the display mode three in which the display subunit 11 corresponding to the white channel and the display subunit 12 corresponding to the plurality of primary color channels cooperate. When the display mode one needs to be realized, only the second gate circuit 22 can be turned on, and only the TFT of the display subunit 11 corresponding to the white channel is turned on; when the display mode two needs to be realized, only the first gate circuit 21 can be turned on, then the TFT of the display subunit 12 corresponding to each of the primary color channels is turned on, and the TFT of the display subunit 11 corresponding to the white channel is not turned on; when the display mode three needs to be realized, the first gate 21 and the second gate 22 can be turned on together, and the TFTs of all the display subunits are turned on.

In the embodiment of the present disclosure, the display panel includes a plurality of display units of a plurality of pixels, each display unit including a display subunit corresponding to a white channel and a plurality of display subunits corresponding to primary color channels, wherein the display areas of the display subunits corresponding to the plurality of primary color channels are equal, and the display area of the display subunit corresponding to the white channel is larger than the display area of each display subunit corresponding to each primary color channel. In this way, the display subunit corresponding to the white channel having a large display area is added to each pixel, and the color filter of the display subunit corresponding to the white channel has a strong light-transmitting ability. Therefore, when the screen brightness requirement is the same, with the display panel provided in the present solution, a lower light intensity of the backlight is needed, which can save the power consumed by the backlight.

Other embodiments of the present disclosure will be readily apparent to those skilled in the art upon consideration of the specification and practice of the disclosure disclosed herein. The present application is intended to cover any variations, uses, or adaptations of the present disclosure that follow the general principles of the present disclosure and include the common general knowledge or conventional technical means in the art without departing from the present disclosure. The specification and examples are to be regarded as illustrative only, and the true scope of the disclosure is indicated by the following claims.

It is to be understood that this disclosure is not limited to the precise constructions described above and shown in the accompanying drawings, and that various modifications and changes may be made without departing from the scope thereof. The scope of the present disclosure is limited only by the appended claims.

## Claims

1. A display panel, wherein the display panel includes a plurality of display units of pixels (1), each of the display units including a display subunit (11) corresponding to a white channel and display subunits (12) corresponding to a plurality of primary color channels, wherein display areas of the display subunits (12) corresponding to the plurality of primary color channels are equal, and the display area of the display subunit (11) corresponding to the white channel is larger than the display area of each display subunit (12) corresponding to each primary color channel,
wherein each of the display subunits (11, 12) comprises a TFT (13),
**characterized in that**
the display panel includes a first gate circuit (21), a second gate circuit (22), and a data circuit (3), a source electrode of each TFT (13) is connected to the data circuit (3), a gate electrode of the TFT (13) of the display subunit (12) corresponding to each of the primary color channels is connected to the first gate circuit (21), and a gate electrode of the TFT (13) of the display subunit (11) corresponding to each of the white channels is connected to the second gate circuit (22).

2. The display panel according to claim 1, **characterized in that** the plurality of primary color channels includes a red channel, a blue channel, and a green channel.

3. The display panel according to claim 1 or 2, **characterized in that** the display areas of the display subunits (12) corresponding to the plurality of primary color channels and the display area of the display subunit (11) corresponding to the white channel are rectangular display areas arranged parallel and the lengths of the rectangular display areas are equal.

4. The display panel according to any one of claims 1-3, **characterized in that** the rectangular display areas of the display subunits (11, 12) in each of the display units are arranged in the same order, and are parallel with each other with long-sides thereof being arranged vertically.

5. The display panel according to any one of claims 1-3, **characterized in that** the rectangular display areas of the display subunits (11, 12) in each of the display units are arranged in the same order, and are parallel with each other with long-sides thereof being arranged horizontally.

6. The display panel according to any one of claims 1-5, **characterized in that** the display area of the display subunit (11) corresponding to the white channel is less than half of the display area of the display unit (1).

7. The display panel according to any one of claims 1-6, **characterized in that** the display area of the display subunit (11) corresponding to the white channel accounts for 1/3 of the display area of the display unit (1).

## Patentansprüche

1. Anzeigepanel, wobei das Anzeigepanel eine Vielzahl von Anzeigeeinheiten aus Pixeln (1) aufweist, wobei jede Anzeigeeinheit eine Anzeigeuntereinheit (11), die einem Weißkanal entspricht, und Anzeigeuntereinheiten (12), die einer Vielzahl von Primärfarbkanälen entsprechen, aufweist, wobei die Anzeigebereiche der Anzeigeuntereinheiten (12), die der Vielzahl von Primärfarbkanälen entsprechen, gleich sind und der Anzeigebereich der Anzeigeuntereinheit (11), die dem Weißkanal entspricht, größer ist als der Anzeigebereich jeder Anzeigeuntereinheit (12), die dem Primärfarbkanal entspricht,
wobei sämtliche Anzeigeuntereinheiten (11, 12) einen TFT (13) aufweisen,
**dadurch gekennzeichnet, dass**
das Anzeigepanel eine erste Gate-Schaltung (21), eine zweite Gate-Schaltung (22) und eine Datenschaltung (3) aufweist, wobei eine Source-Elektrode jedes TFT (13) mit der Datenschaltung (3) verbunden ist, wobei eine Gate-Elektrode des TFT (13) der Anzeigeuntereinheit (12), die sämtlichen Primärfarbkanälen entspricht, mit der ersten Gate-Schaltung (21) verbunden ist, und wobei eine Gate-Elektrode des TFT (13) der Anzeigeuntereinheit (11), die sämtlichen Weißkanälen entspricht, mit der zweiten Gate-Schaltung (22) verbunden ist.

2. Anzeigepanel nach Anspruch 1, **dadurch gekennzeichnet, dass** die Vielzahl von Primärfarbkanälen einen Rotkanal, einen Blaukanal und einen Grünkanal aufweist.

3. Anzeigepanel nach Anspruch 1 oder 2, **dadurch gekennzeichnet, dass** die Anzeigebereiche der Anzeigeuntereinheiten (12), die der Vielzahl von Primärfarbkanälen entsprechen, und der Anzeigebereich der Anzeigeunter-einheit (11), die dem Weißkanal entspricht, rechteckige Anzeigebereiche sind, die parallel angeordnet sind, wobei die Längen der rechteckigen Anzeigebereiche gleich sind.

4. Anzeigepanel nach einem der Ansprüche 1-3, **dadurch gekennzeichnet, dass** die rechteckigen Anzeigebereiche der Anzeigeuntereinheiten (11, 12) in sämtlichen Anzeigeeinheiten in der gleichen Reihenfolge angeordnet und parallel zueinander sind, wobei deren langen Seiten vertikal angeordnet sind.

5. Anzeigepanel nach einem der Ansprüche 1-3, **dadurch gekennzeichnet, dass** die rechteckigen Anzeigebereiche der Anzeigeuntereinheiten (11, 12) in sämtlichen Anzeigeeinheiten in der gleichen Reihenfolge angeordnet und parallel zueinander sind, wobei deren langen Seiten horizontal angeordnet sind.

6. Anzeigepanel nach einem der Ansprüche 1-5, **dadurch gekennzeichnet, dass** der Anzeigebereich der Anzeigeuntereinheit (11), die dem Weißkanal entspricht, kleiner ist als die Hälfte des Anzeigebereichs der Anzeigeeinheit (1).

7. Anzeigepanel nach einem der Ansprüche 1-6, **dadurch gekennzeichnet, dass** der Anzeigebereich der Anzeigeuntereinheit (11), die dem Weißkanal entspricht, 1/3 des Anzeigebereichs der Anzeigeeinheit (1) ausmacht.

## Revendications

1. Panneau d'affichage, dans lequel le panneau d'affichage comporte une pluralité d'unités d'affichage de pixels (1), chacune des unités d'affichage comportant une sous-unité d'affichage (11) correspondant à un canal blanc et des sous-unités d'affichage (12) correspondant à une pluralité de canaux de couleurs primaires, dans lequel les zones d'affichage des sous-unités d'affichage (12) correspondant à la pluralité de canaux de couleur primaire sont égales, et la zone d'affichage de la sous-unité d'affichage (11) correspondant au canal blanc est plus grande que la zone d'affichage de chaque sous-unité d'affichage (12) correspondant à chaque canal de couleur primaire,
dans lequel chacune des sous-unités d'affichage (11, 12) comprend un TFT (13),
**caractérisé par le fait que**
le panneau d'affichage comporte un premier circuit de porte (21), un deuxième circuit de porte (22) et un circuit de données (3), une électrode de source de chaque TFT (13) est connectée au circuit de données (3), une électrode de porte du TFT (13) de la sous-unité d'affichage (12) correspondant à chacun des canaux de couleur primaire est connectée au premier circuit de porte (21), et une électrode de porte du TFT (13) de la sous-unité d'affichage (11) correspondant à chacun des canaux blancs est connectée au deuxième circuit de porte (22).

2. Panneau d'affichage selon la revendication 1, **caractérisé par le fait que** la pluralité de canaux de couleur primaire comporte un canal rouge, un canal bleu et un canal vert.

3. Panneau d'affichage selon la revendication 1 ou 2, **caractérisé par le fait que** les zones d'affichage des sous-unités d'affichage (12) correspondant à la pluralité de canaux de couleur primaire et la zone d'affichage de la sous-unité d'affichage (11) correspondant au canal blanc sont des zones d'affichage rectangulaires disposées en parallèle et les longueurs des zones d'affichage rectangulaires sont égales.

4. Panneau d'affichage selon l'une quelconque des revendications 1 à 3, **caractérisé par le fait que** les zones d'affichage rectangulaires des sous-unités d'affichage (11, 12) dans chacune des unités d'affichage sont disposées selon le même ordre, et sont parallèles entre elles, leurs côtés longs étant disposés verticalement.

5. Panneau d'affichage selon l'une quelconque des revendications 1 à 3, **caractérisé par le fait que** les zones d'affichage rectangulaires des sous-unités d'affichage (11, 12) dans chacune des unités d'affichage sont disposées selon le même ordre, et sont parallèles entre elles, leurs côtés longs étant disposés horizontalement.

6. Panneau d'affichage selon l'une quelconque des revendications 1 à 5, **caractérisé par le fait que** la zone d'affichage de la sous-unité d'affichage (11) correspondant au canal blanc est de moins de la moitié de la zone d'affichage de l'unité d'affichage (1).

7. Panneau d'affichage selon l'une quelconque des revendications 1 à 6, **caractérisé par le fait que** la zone d'affichage de la sous-unité d'affichage (11) correspondant au canal blanc correspond à 1/3 de la zone d'affichage de l'unité d'affichage (1).
